(19)

Europäisches Patentamt
European Patent Office
Office européen des brevets

(11) **EP 4 468 739 A2**

(12) **EUROPEAN PATENT APPLICATION**
published in accordance with Art. 153(4) EPC

(43) Date of publication:
**27.11.2024 Bulletin 2024/48**

(51) International Patent Classification (IPC):
**H04R 3/00** *(2006.01)* **H04R 1/10** *(2006.01)*
**H04R 17/00** *(2006.01)*

(21) Application number: **24700169.6**

(22) Date of filing: **09.01.2024**

(86) International application number:
**PCT/KR2024/000370**

(87) International publication number:
**WO 2024/214920 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **12.04.2023 KR 20230048284
19.05.2023 KR 20230064997**

(71) Applicant: **Samsung Electronics Co., Ltd.
Suwon-si, Gyeonggi-do 16677 (KR)**

(72) Inventors:
• **KIM, Sungjin
Suwon-si
Gyeonggi-do 16677 (KR)**
• **LEE, Byeongmin
Suwon-si
Gyeonggi-do 16677 (KR)**
• **CHANG, Juhee
Suwon-si
Gyeonggi-do 16677 (KR)**

(74) Representative: **Gulde & Partner
Patent- und Rechtsanwaltskanzlei mbB
Wallstraße 58/59
10179 Berlin (DE)**

(54) **ELECTRONIC DEVICE FOR OUTPUTTING SOUND AND SOUND OUTPUT METHOD USING SAME**

(57)    An electronic device outputting a sound according to embodiments of the disclosure may comprise memory storing at least one instruction, a processor executing the at least one instruction, at least one speaker, and an audio processing module processing the input audio signal and outputting the processed input audio signal to the at least one speaker. The audio processing module may include a digital amplifier amplifying a digital audio signal, a digital-to-analog converter (DAC) converting the digital audio signal into an analog audio signal, an analog amplifier amplifying the analog audio signal, a boost amplifier boosting the analog audio signal to a reference high voltage or more, and at least one noise gate removing noise included in the analog audio signal. The digital amplifier may apply a positive (+) digital gain to the digital audio signal. The analog amplifier may apply a negative (-) analog gain to the analog audio signal.

*FIG.4*

EP 4 468 739 A2

# Description

## [TECHNICAL FIELD]

Various embodiments of the disclosure relate to an electronic device outputting a sound and a sound output method using the same.

## [BACKGROUND ART]

The development of digital technology leads to wide use of various electronic devices, such as earphones, earbuds, wireless speakers, or wireless headsets for outputting the audio data reproduced on audio source devices, such as mobile communication terminals, personal digital assistants (PDAs), electronic wallets, smartphones, tablets, personal computers (PCs), or wearable devices. The electronic device may receive audio data from the audio source device through wireless communication connection with the audio source device.

In relation to the above-described wireless communication connection technology, the Bluetooth standard technology defines a protocol for short-range wireless communication between electronic devices. In a Bluetooth network environment, electronic devices may transmit or receive data packets including content, such as text, voice, images, or videos, in a designated frequency band. For example, user equipment (UE), such as a smartphone, a tablet, a desktop computer, or a laptop computer, may transmit data packets to another UE or an accessory device.

Each electronic device (e.g., a pair of wireless earphones or a wireless speaker) may generate an independent communication link (e.g., audio over Bluetooth low energy (AoBLE) topology) with the UE (e.g., smartphone) and provide the same purpose and the same service. For electronic devices to provide the same purpose and the same service, matching or coupling between the electronic devices may be performed.

## [DISCLOSURE]

## [TECHNICAL PROBLEM]

Various embodiments of the disclosure may provide an electronic device that performs dynamic range enhancement (DRE) on the input audio signal, boosts the input audio signal, and removes noise generated while processing audio.

## [TECHNICAL SOLUTION]

An electronic device outputting a sound according to embodiments of the disclosure comprises memory storing at least one instruction, a processor executing the at least one instruction, at least one speaker, and an audio processing module processing the input audio signal and outputting the processed input audio signal to the at least one speaker. The audio processing module includes a digital amplifier amplifying a digital audio signal, a digital-to-analog converter (DAC) converting the digital audio signal into an analog audio signal, an analog amplifier amplifying the analog audio signal, a boost amplifier boosting the analog audio signal to a reference high voltage or more, and at least one noise gate removing noise included in the analog audio signal. The digital amplifier applies a positive (+) digital gain to the digital audio signal. The analog amplifier applies a negative (-) analog gain to the analog audio signal.

An audio processing module processing an input audio signal and outputting the processed input audio signal to at least one speaker according to embodiments of the disclosure comprises a digital amplifier amplifying a digital audio signal, a digital-to-analog converter (DAC) converting the digital audio signal into an analog audio signal, an analog amplifier amplifying the analog audio signal, a boost amplifier boosting the analog audio signal to a reference high voltage or more, and at least one noise gate removing noise included in the analog audio signal. The digital amplifier applies a positive (+) digital gain to the digital audio signal. The analog amplifier applies a negative (-) analog gain to the analog audio signal.

A method for outputting a sound according to embodiments of the disclosure comprises amplifying a digital audio signal, converting the digital audio signal into an analog audio signal, amplifying the analog audio signal, boosting the analog audio signal to a reference high voltage or more, removing noise included in the analog audio signal, and outputting the analog audio signal to at least one speaker. Amplifying the digital audio signal applies a positive (+) digital gain to the digital audio signal. Amplifying the analog audio signal applies a negative (-) analog gain to the analog audio signal.

## [ADVANTAGEOUS EFFECTS]

According to various embodiments of the disclosure, an electronic device outputting a sound and a sound output method using the electronic device according to the disclosure may implement a noise-minimized, high-resolution sound by performing dynamic range enhancement (DRE) on an input audio signal and removing noise generated while processing audio, using a noise gate.

Further, an electronic device outputting a sound and a sound output method using the electronic device according to the disclosure may drive a piezo speaker which requires high-voltage output by boosting an input audio signal to a reference high voltage or more.

Effects of the disclosure are not limited to the foregoing, and other unmentioned effects would be apparent to one of ordinary skill in the art from the following description. In other words, unintended effects in practicing embodiments of the disclosure may also be derived by one of ordinary skill in the art from the embodiments of the disclosure.

[DESCRIPTION OF DRAWINGS]

FIG. 1 is a block diagram illustrating a configuration of an electronic device in a network environment according to an embodiment;
FIG. 2 is a block diagram illustrating a configuration of an audio module according to an embodiment;
FIG. 3 is a block diagram illustrating a configuration of an electronic device processing an audio signal to output a sound through a speaker according to an embodiment;
FIG. 4 is a block diagram illustrating an audio processing module according to an embodiment;
FIG. 5 is a block diagram illustrating an audio processing module according to an embodiment;
FIG. 6 is a block diagram illustrating an audio processing module according to an embodiment;
FIG. 7 is a block diagram illustrating an audio processing module according to an embodiment;
FIG. 8 is a block diagram illustrating an audio processing module according to an embodiment;
FIG. 9 is a block diagram illustrating an audio processing module according to an embodiment;
FIG. 10 is a block diagram illustrating an audio processing module according to an embodiment;
FIG. 11 is a view illustrating a sound output method using an electronic device according to an embodiment;
FIG. 12A is a block diagram illustrating a configuration of a wearable electronic device according to an embodiment;
FIG. 12B is a view illustrating an external configuration of a wearable electronic device according to an embodiment;
FIG. 12C is a view illustrating an internal configuration of a wearable electronic device according to an embodiment; and
FIG. 13 is a view illustrating a wearable device electrically connected to an electronic device according to an embodiment.

[BEST MODE]

Embodiments of the disclosure are now described with reference to the accompanying drawings in such a detailed manner as to be easily practiced by one of ordinary skill in the art. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

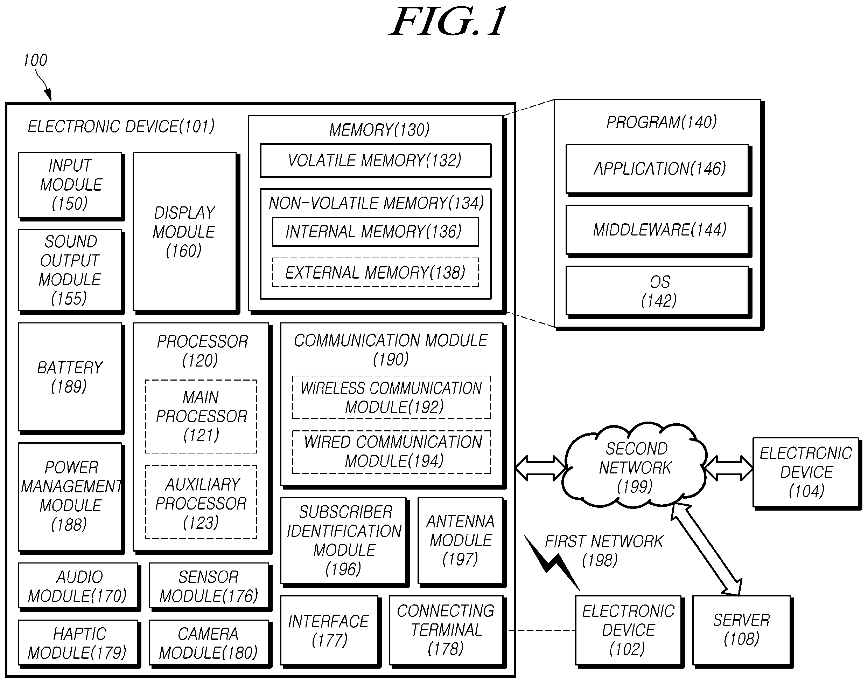

FIG. 1 is a block diagram illustrating an electronic device 101 in a network environment 100 according to an embodiment.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth™, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

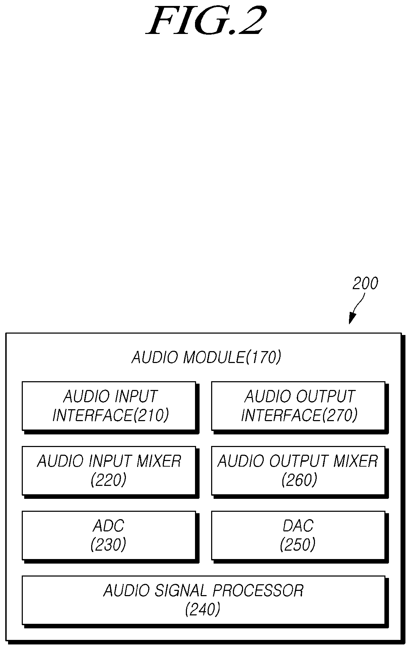

FIG. 2 is a block diagram illustrating a configuration of an audio module 170 according to an embodiment.

Referring to FIG. 2, the audio module 170 may include, for example, an audio input interface 210, an audio input mixer 220, an analog-to-digital converter (ADC) 230, an audio signal processor 240, a digital-to-analog converter (DAC) 250, an audio output mixer 260, or an audio output interface 270.

The audio input interface 210 may receive an audio signal corresponding to a sound obtained from the outside of the electronic device 101 via a microphone (e.g., a dynamic microphone, a condenser microphone, or a piezo microphone) that is configured as part of the input module 150 or separately from the electronic device 101. For example, if an audio signal is obtained from the external electronic device 102 (e.g., a headset or a microphone), the audio input interface 210 may be connected with the external electronic device 102 directly via the connecting terminal 178, or wirelessly (e.g., Bluetooth™ communication) via the wireless communication module 192 to receive the audio signal. According to an embodiment, the audio input interface 210 may receive a control signal (e.g., a volume adjustment signal received via an input button) related to the audio signal obtained from the external electronic device 102. The audio input interface 210 may include a plurality of audio input channels and may receive a different audio signal via a corresponding one of the plurality of audio input channels, respectively. According to an embodiment, additionally or alternatively, the audio input interface 210 may receive an audio signal from another component (e.g., the processor 120 or the memory 130) of the electronic device 101.

The audio input mixer 220 may synthesize a plurality of inputted audio signals into at least one audio signal. For example, according to an embodiment, the audio input mixer 220 may synthesize a plurality of analog audio signals inputted via the audio input interface 210 into at least one analog audio signal.

The ADC 230 may convert an analog audio signal into a digital audio signal. For example, according to an embodiment, the ADC 230 may convert an analog audio signal received via the audio input interface 210 or, additionally or alternatively, an analog audio signal synthesized via the audio input mixer 220 into a digital audio signal.

The audio signal processor 240 may perform various processing on a digital audio signal received via the ADC 230 or a digital audio signal received from another component of the electronic device 101. For example, according to an embodiment, the audio signal processor 240 may perform changing a sampling rate, applying one or more filters, interpolation processing, amplifying or attenuating a whole or partial frequency bandwidth, noise processing (e.g., attenuating noise or echoes), changing channels (e.g., switching between mono and stereo), mixing, or extracting a specified signal for one or more digital audio signals. According to an embodiment, one or more functions of the audio signal processor 240 may be implemented in the form of an equalizer.

The DAC 250 may convert a digital audio signal into an analog audio signal. For example, according to an embodiment, the DAC 250 may convert a digital audio signal processed by the audio signal processor 240 or a digital audio signal obtained from another component (e.g., the processor(120) or the memory(130)) of the electronic device 101 into an analog audio signal.

The audio output mixer 260 may synthesize a plurality of audio signals, which are to be outputted, into at least one audio signal. For example, according to an embodiment, the audio output mixer 260 may synthesize an analog audio signal converted by the DAC 250 and another analog audio signal (e.g., an analog audio signal received via the audio input interface 210) into at least one analog audio signal.

The audio output interface 270 may output an analog audio signal converted by the DAC 250 or, additionally or alternatively, an analog audio signal synthesized by the audio output mixer 260 to the outside of the electronic device 101 via the sound output module 155. The sound output module 155 may include, for example, a speaker, such as a dynamic driver or a balanced armature driver, or a receiver. According to an embodiment, the sound output module 155 may include a plurality of speakers. In such a case, the audio output interface 270 may output audio signals having a plurality of different channels (e.g., stereo channels or 5.1 channels) via at least some of the plurality of speakers. According to an embodiment, the audio output interface 270 may be connected with the external electronic device 102 (e.g., an external speaker or a headset) directly via the connecting terminal 178 or wirelessly via the wireless communication module 192 to output an audio signal.

According to an embodiment, the audio module 170 may generate, without separately including the audio input mixer 220 or the audio output mixer 260, at least one digital audio signal by synthesizing a plurality of digital audio signals using at least one function of the audio signal processor 240.

According to an embodiment, the audio module 170 may include an audio amplifier (not shown) (e.g., a speaker amplifying circuit) that is capable of amplifying an analog audio signal inputted via the audio input interface 210 or an audio signal that is to be outputted via the audio output interface 270. According to an embodiment, the audio amplifier may be configured as a module separate from the audio module 170.

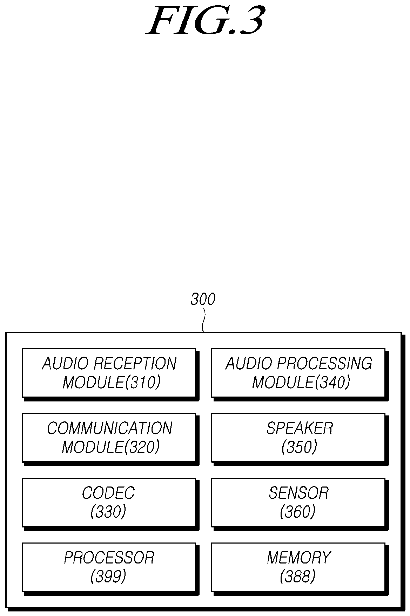

FIG. 3 is a block diagram illustrating a configuration of an electronic device 300 processing an audio signal to output a sound through a speaker according to an embodiment.

The electronic device 300 (e.g., the electronic device 101 of FIG. 1) may include an audio reception module 310, a communication module 320, a codec 330, an audio processing module 340, a speaker 350, a sensor 360, memory 388, and a processor 399. The components of the electronic device 300 may be operatively or electrically connected to each other.

In an embodiment, the audio reception module 310 may receive an audio file from an audio source. For example, the audio reception module 310 may receive an audio file automatically or manually selected by the user or a server as audio to be played (e.g., streamed) from an external audio source (e.g., a streaming media server) via the communication module 320 (e.g., the wireless communication module 192 of FIG. 1), and store the audio file in a buffer (e.g., the memory 388). For example, the audio reception module 310 may retrieve an audio file selected by the user as audio to be reproduced among audio files stored in an internal audio source (e.g., the memory 388).

In an embodiment, the codec 330 may decode the audio file received by the audio reception module 310 into a digital audio signal. For example, the codec 330 may decompress an audio file compressed in a lossy compression format such as MP3 or advanced audio coding (AAC) into a reproducible digital audio signal. The codec 330 may decompress an audio file compressed in a lossless compression format such as the true audio (TA) or free lossless audio codec (FLAC) into a digital audio signal. In addition to the illustrated format, audio files of various formats may be decompressed by the codec 330.

In an embodiment, the audio processing module 340 may identify the format of the audio file. For example, the audio processing module 340 may identify format information constituting the digital audio signal (e.g., digital data) in the audio file (e.g., the header) obtained from the codec 330. For example, the audio processing module 340 may identify at least one of the bit rate, the sampling rate, the bit depth, and the number of channels. The bit rate is defined as the number of bits processed every unit time (e.g., 1 second), and the bit per second (bps) may be used as the unit. As the bit rate increases, it may be understood that the corresponding audio file has higher quality (e.g., fidelity). The sampling rate may be defined as the number of samples extracted from the original sound per unit time (e.g., 1 second), and the unit may be Hertz. For example, an audio file having a sampling rate of 48 kHz may be understood as an audio file included in multimedia rather than music. The bit depth corresponds to the resolution of the image, and may be an indicator indicating how detailed the amplitude of the audio signal may be expressed, and the unit thereof may be the bit. The larger the bit depth, the higher the resolution of the corresponding audio file. The number of channels may be, e.g., at least one of 1 (mono), 2 (stereo), 5.1, and 7.1.

According to an embodiment, the audio processing module 340 may process the digital audio signal (e.g., digital data) based on the format information. For example, the audio processing module 340 may estimate the type (or purpose) (e.g., music, multimedia, voice, high resolution, or surround sound) of the corresponding audio file using the format information, and process the digital audio signal using the type-based processing scheme, thereby providing a sound field effect expected by the user when playing audio. The processing method may include at least one of adjusting the height (frequency), the volume, or the tone in the audio signal, amplifying (or attenuating) the audio component of a specific frequency band in the audio signal, synthesizing a sound effect (e.g., the echo) in the audio signal, removing noise from the audio signal, gradually increasing (or decreasing) the sound, and making the low sound lower and the high sound higher in the audio signal. The processing method may include other various processing methods than those described above. The audio processing module 340 may configure a processing method based on the type of the audio file using at least one of the above-described operations, and may apply the processing method based on the type of the audio file to the processing of the digital data.

In an embodiment, the audio processing module 340 may process the digital audio signal based on the bit depth. For example, if the bit depth is greater than or equal to a designated value (e.g., 24 bits), the audio processing module 340 may regard the corresponding audio file as a high-resolution audio file, and may apply a processing method for emphasizing the characteristics of the high resolution and minimizing distortion to the audio signal received from the codec 330 so that the audio is reproduced to be close to the original sound. For example, when the speaker 350 has performance lower than a designated reference, the audio processing module 340 may emphasize (e.g., amplify) an audio component belonging to a frequency band higher than a designated first frequency (e.g., about 16 kHz) and an audio component belonging to a frequency band lower than a designated second frequency (e.g., about 40 Hz) in the audio signal.

For example, the speaker 350 may be connected to the electronic device 300 through an audio connector or the communication module 320. The electronic device 300 may receive the specifications (e.g., the reproducible frequency band, the sound pressure level, the recommended amplifier output, or the impedance) regarding the performance of the speaker 350 from the speaker 350 via the audio connector or the communication module 320. The electronic device 300 may determine that the speaker 350 is a device having performance greater than or equal to a designated reference based on the received performance information. According to the determination, the audio processing module 340 may output the audio signal to the speaker 350 without the emphasis processing as described above.

In an embodiment, the audio processing module 340 may process digital data based on the number of channels. For example, when the number of channels is one, the audio processing module 340 may regard the corresponding digital data as voice data (e.g., online lectures) for information transmission, and may emphasize (e.g., amplify) an audio component belonging to a specific frequency (e.g., about 1 kHz) in the digital data for clear information transmission. For example, when the number of channels exceeds two, the audio processing module 340 may regard the corresponding digital data as audio data having surround sound, and may apply a processing method for emphasizing a three-dimensional effect and a sense of presence to the audio signal received from the codec 330. For example, when the number of channels is two, the audio processing module 340 may output the audio signal to the speaker without applying the above-described processing method to the digital data.

In an embodiment, the audio processing module 340 may process digital data based on the sampling rate. For example, when the sampling rate is a designated first value (e.g., 44.1 kHz), the audio processing module 340 may regard the corresponding digital data as music data. When the digital data is regarded as music data, the audio processing module 340 may output the audio signal received from the codec 330 to the speaker. When the sampling rate is a designated second value (e.g., 48 kHz) greater than the first value, the audio processing module 340 may regard the corresponding digital data as audio data included in multimedia (e.g., a movie or a game). When the sampling rate is the second value, the audio processing module 340 may process the audio signal received from the codec 330 so that a dynamic effect appears on the multimedia. When the sampling rate is greater than or equal to a designated third value (e.g., 96 kHz) greater than the second value, the audio processing module 340 may regard the corresponding digital data as high-resolution audio data and process the audio signal received from the codec 330 based on the performance of the speaker. For example, when the speaker 350 has a performance lower than a designated reference, the audio processing module 340 may emphasize (e.g., amplify) audio components of a designated low frequency band (e.g., less than 40 Hz) and a high frequency band (e.g., 16 kHz or more) in the audio signal received from the codec 330. When the speaker 350 has a performance greater than or equal to the designated reference, the audio processing module 340 may output the audio signal received from the codec 330 to a reproducing device without the emphasis processing as described above.

In an embodiment, the audio processing module 340 may process digital data based on the bit rate. For example, when the bit rate exceeds 100 kbps, the audio processing module 340 may regard the digital data as audio data compressed to have less loss. Accordingly, the audio processing module 340 may output the audio signal received from the codec 330 to the reproducing device. When the bit rate is 100 kbps or less, the audio processing module 340 may regard the corresponding digital data as audio data compressed to have relatively more loss. When the bit rate is 100 kbps or less, the audio processing module 340 may perform an operation of restoring an audio component of a high frequency band (e.g., 11 kHz or more) lost in the process of compressing the audio signal or an operation of attenuating audio components of a high frequency band and a low frequency band.

In an embodiment, the audio processing module 340 may include a digital-to-analog converter (DAC) (e.g., the DAC 250 of FIG. 2). The DAC may convert the digital audio signal into an analog audio signal and output the analog audio signal to the speaker 350. The speaker 350 may convert the received analog audio signal into a sound wave and output the sound wave. For example, the audio processing module 340 may select a device to reproduce the digital data. The audio processing module 340 may select the speaker 350 of the electronic device 300 as a reproducing device through the communication module 320 (e.g., a Bluetooth module or a Wi-Fi module).

The sensor 360 (e.g., the sensor module 176 of FIG. 1) may include at least one of a proximity sensor, a contact sensor, a touch sensor, and an acceleration sensor. The proximity sensor may detect that an external object (e.g., the user's ear) approaches the electronic device 300 within a predetermined distance. The proximity sensor may be implemented as an optical proximity sensor, but is not limited thereto. For example, the proximity sensor may be implemented as any one of a magnetic proximity sensor, an ultrasonic proximity sensor, and an inductive proximity sensor. The contact sensor may detect the contact of the external object when the external object is a part of the body. For example, the contact sensor may be implemented as a capacitive type sensor, and may not output a signal corresponding to contact detection when an external object other than a part of the body contacts. For example, the contact sensor may be configured as an integrated circuit (IC) integrated with the touch sensor. The touch sensor may receive the user's touch input. For example, the touch sensor may be used as an input means for performing a control operation of the electronic device 300 related to audio output. The acceleration sensor may detect the acceleration of the electronic device 300 and the intensity of the impact. For example, the acceleration sensor may be at least one of an inertia sensor and a gyroscope.

The memory 388 (e.g., the memory 130 of FIG. 1) may store at least one instruction. For example, the memory 388 may store instructions necessary for the operation of the audio processing module 340. The processor 399 (e.g., the processor 120 of FIG. 1) may operate the audio processing module 340 by executing the at least one instruction. For example, the audio processing module 340 may be executed by a processor (e.g., the auxiliary processor 123 of FIG. 1 or the audio signal processor 240 of FIG. 2) specialized for audio signal processing.

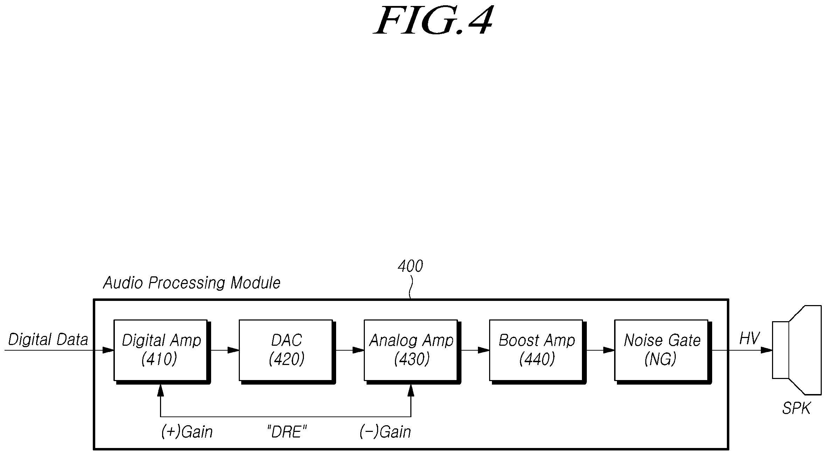

FIG. 4 is a block diagram illustrating an audio processing module 400 according to an embodiment.

Referring to FIG. 4, an audio processing module 400 (e.g., the audio processing module 340 of FIG. 3) of the disclosure may receive an input audio signal from a codec (e.g., the codec 330 of FIG. 3). The input audio signal may include a digital audio signal (e.g., digital data). The audio processing module 400 may output the input audio signal to at least one speaker (e.g., the speaker 350 of FIG. 3) by processing the input audio signal.

The at least one speaker may include a piezo speaker. For example, the piezo speaker may be at least one of a disk piezo speaker, a bass strip piezo speaker, a tweeter piezo speaker, a glass/ceramic piezo speaker, and a plain form piezo speaker. The piezo speaker may output sound by directly driving the internal diaphragm. Accordingly, the piezo speaker may require a high voltage output for driving the diaphragm.

The audio processing module 400 may include a digital amplifier 410 amplifying a digital audio signal, a digital-to-analog converter (DAC) 420 converting the digital audio signal into an analog audio signal, an analog amplifier 430 amplifying the analog audio signal, a boost amplifier 440 boosting the analog audio signal to a reference high voltage or more, and at least one noise gate NG removing noise included in the analog audio signal.

The digital amplifier 410 may amplify the digital audio signal in a digital manner by applying a digital gain to the digital audio signal. For example, the digital amplifier 410 may amplify the magnitude of the output digital audio signal by converting the input digital audio signal into a number and adjusting the size of the number multiplied by the digital audio signal.

The DAC 420 may receive the digital audio signal from the digital amplifier 410 and convert the digital audio signal into an analog audio signal. For example, the DAC 420 may generate an analog audio signal by converting the digital audio signal from the binary number to an analog voltage.

The analog amplifier 430 may amplify the analog audio signal in an analog manner by applying an analog gain to the analog audio signal. For example, the analog amplifier 430 may amplify the magnitude of the output analog audio signal by adjusting the voltage multiplied by the input analog audio signal.

The boost amplifier 440 may boost the analog audio signal to a reference high voltage or more. For example, the boost amplifier 440 may generate a high voltage output for driving the piezo speaker by boosting the analog audio signal. The reference high voltage may be a minimum voltage for driving the piezo speaker. For example, the reference high voltage may have a voltage level of 27V to 33V

At least one noise gate NG may remove noise included in the analog audio signal. For example, the at least one noise gate NG may remove at least one of DAC noise generated in the DAC 420, analog amplifier noise generated in the analog amplifier 430, or boost amplifier noise generated in the boost amplifier 440. The at least one noise gate NG may output the noise-removed analog audio signal to the at least one speaker.

In an embodiment, the electronic device may perform dynamic range enhancement (DRE) on the input audio signal. The DRE may increase the dynamic range of the input audio signal and minimize noise and distortion of the input audio signal. For example, the digital amplifier 410 may apply a positive (+) digital gain to the digital audio signal. For example, the analog amplifier 430 may apply a negative (-) analog gain to the analog audio signal.

The magnitude of the digital gain and the magnitude of the analog gain may be the same. For example, the digital amplifier 410 and the analog amplifier 430 may perform dynamic range enhancement (DRE) by setting the positive (+) digital gain and the negative (-) analog gain so that a total gain of the positive (+) digital gain and the negative (-) analog gain becomes 0dB.

As such, the electronic device may implement a noise-minimized, high-resolution sound by performing DRE on an input audio signal and removing noise generated while processing audio, using the noise gate NG.

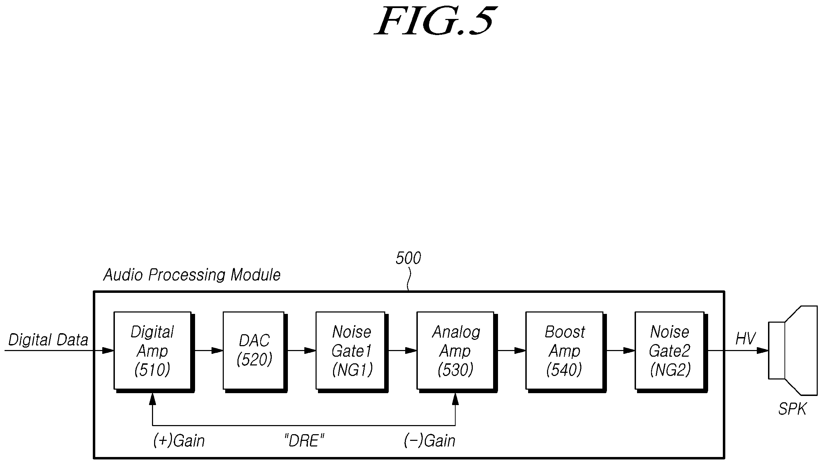

FIG. 5 is a block diagram illustrating an audio processing module 500 according to an embodiment.

Referring to FIG. 5, an audio processing module 500 (e.g., the audio processing module 340 of FIG. 3) may include a digital amplifier 510, a DAC 520, a first noise gate NG1, an analog amplifier 530, a boost amplifier 540, and a second noise gate NG2. Like the audio processing module 400 of FIG. 4, the digital amplifier 510 and the analog amplifier 530 may perform dynamic range enhancement (DRE) by setting the positive (+) digital gain and the negative (-) analog gain so that a total gain of the positive (+) digital gain and the negative (-) analog gain becomes 0dB. Further, like the audio processing module 400 of FIG. 4, the boost amplifier 540 may generate a high voltage output for driving the piezo speaker by boosting the analog audio signal.

The audio processing module 500 may include a first noise gate NG1 disposed between the DAC 520 and the analog amplifier 530, and a second noise gate NG2 disposed between the boost amplifier 540 and the at least one speaker. For example, the first noise gate NG1 may remove DAC noise generated in the DAC 520. For example, the second noise gate NG2 may remove analog amplifier noise generated in the analog amplifier 530 and boost amplifier noise generated in the boost amplifier 540.

The first noise gate NG1 may remove the DAC noise generated in the DAC 520 and output the DAC noise-removed analog audio signal to the analog amplifier 530. The DAC noise may be system noise generated while the DAC 520 converts the digital audio signal into the analog audio signal. For example, a threshold level of the first noise gate NG1 may be set based on DAC noise. For example, the first noise gate NG1 may remove DAC noise as a noise removal signal is input.

The second noise gate NG2 may remove the analog amplifier noise generated in the analog amplifier 530 and the boost amplifier noise generated in the boost amplifier 540, and may output the analog audio signal where the analog amplifier noise and the boost amplifier noise have been removed to at least one speaker. The analog amplifier noise may be noise generated while the analog audio signal is amplified by the analog amplifier 530. The boost amplifier noise may be noise generated while the analog audio signal is boosted by the boost amplifier 540.

For example, the threshold level of the second noise gate NG2 may be determined by Equation 1 below.

[Equation 1]

$$TL = (Noise_{AA} \times Gain_{BA}) + Noise_{BA}$$

Here, TL may be the threshold level of the noise gate, $Noise_{AA}$ may be the analog amplifier noise, $Gain_{BA}$ may be the gain of the boost amplifier 540, and $Noise_{BA}$ may be the boost amplifier noise.

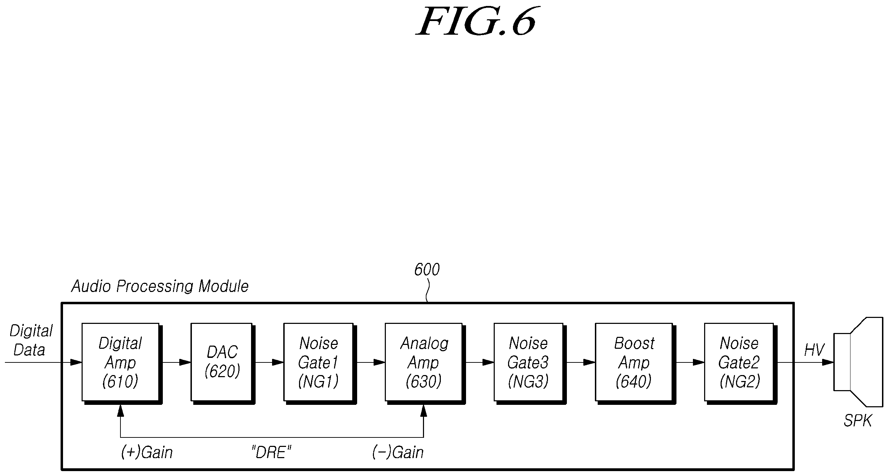

FIG. 6 is a block diagram illustrating an audio processing module 600 according to an embodiment.

Referring to FIG. 6, an audio processing module 600 (e.g., the audio processing module 340 of FIG. 3) may include a digital amplifier 610, a DAC 620, a first noise gate NG1, an analog amplifier 630, a third noise gate NG3, a boost amplifier 640, and a second noise gate NG2. Like the audio processing module 400 of FIG. 4, the digital amplifier 610 and the analog amplifier 630 may perform dynamic range enhancement (DRE) by setting the positive (+) digital gain and the negative (-) analog gain so that a total gain of the positive (+) digital gain and the negative (-) analog gain becomes 0dB. Further, like the audio processing module 400 of FIG. 4, the boost amplifier 640 may generate a high voltage output for driving the piezo speaker by boosting the analog audio signal.

The audio processing module 600 may include a first noise gate NG1 disposed between the DAC 620 and the analog amplifier 630, a second noise gate NG2 disposed between the boost amplifier 640 and the at least one speaker, and a third noise gate NG3 disposed between the analog amplifier 630 and the boost amplifier 640. For example, the first noise gate NG1 may remove DAC noise generated in the DAC 620. For example, the second noise gate NG2 may remove the boost amplifier noise generated in the boost amplifier 640. For example, the third noise gate NG3 may remove analog amplifier noise generated in the analog amplifier 630.

The first noise gate NG1 may remove the DAC noise generated in the DAC 620 and output the analog audio signal from which the DAC noise is removed to the analog amplifier 630. The DAC noise may be system noise generated while the DAC 620 converts the digital audio signal into the analog audio signal. For example, a threshold level of the first noise gate NG1 may be set based on DAC noise. For example, the first noise gate NG1 may remove DAC noise as a noise removal signal is input.

The third noise gate NG3 may remove the analog amplifier noise generated in the analog amplifier 630 and output the analog amplifier noise-removed analog audio signal to the boost amplifier 640. The analog amplifier noise may be noise generated while the analog audio signal is amplified by the analog amplifier 630. For example, a threshold level of the third noise gate NG3 may be set based on analog amplifier noise.

The second noise gate NG2 may remove the boost amplifier noise generated in the boost amplifier 640 and output the boost amplifier noise-removed analog audio signal to at least one speaker. The boost amplifier noise may be noise generated while the analog audio signal is boosted by the boost amplifier 640. For example, the threshold level of the second noise gate NG2 may be set based on boost amplifier noise.

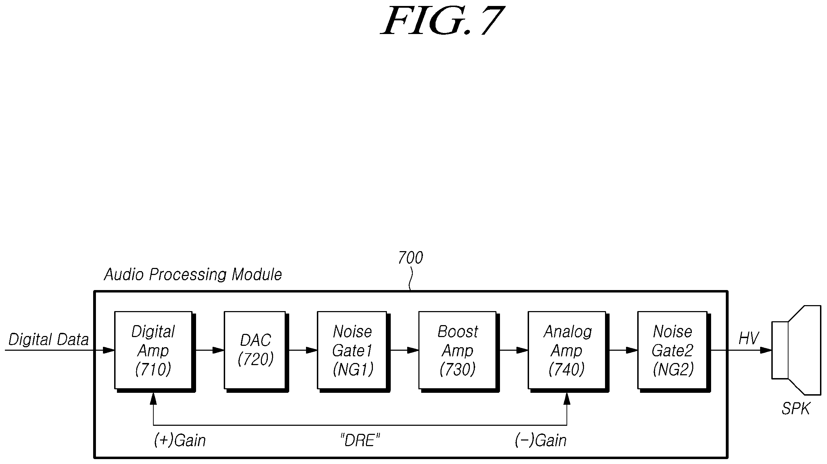

FIG. 7 is a block diagram illustrating an audio processing module 700 according to an embodiment.

Referring to FIG. 7, an audio processing module 700 (e.g., the audio processing module 340 of FIG. 3) may include a digital amplifier 710, a DAC 720, a first noise gate NG1, a boost amplifier 730, an analog amplifier 740, and a second noise gate NG2. Like the audio processing module 400 of FIG. 4, the digital amplifier 710 and the analog amplifier 740 may perform dynamic range enhancement (DRE) by setting the positive (+) digital gain and the negative (-) analog gain so that a total gain of the positive (+) digital gain and the negative (-) analog gain becomes 0dB. Further, like the audio processing module 400 of FIG. 4, the boost amplifier 730 may generate a high voltage output for driving the piezo speaker by boosting the analog audio signal.

Unlike the audio processing module 400 of FIG. 4, the audio processing module 700 of FIG. 7 may boost the analog audio signal for generating high voltage output and then amplify the boosted analog audio signal.

In this case, the analog amplifier 740 may need a higher power supply voltage than the audio processing module 400 of FIG. 4 to amplify the boosted analog audio signal.

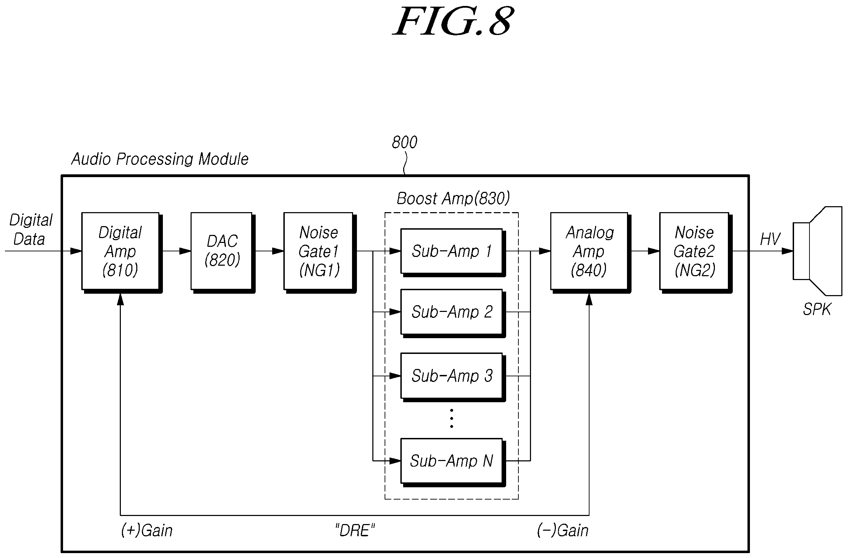

FIG. 8 is a block diagram illustrating an audio processing module 800 according to an embodiment.

Referring to FIG. 8, an audio processing module 800 (e.g., the audio processing module 340 of FIG. 3) may include a digital amplifier 810, a DAC 820, a first noise gate NG1, a boost amplifier 830, an analog amplifier 840, and a second noise gate NG2. Like the audio processing module 700 of FIG. 7, the audio processing module 800 of FIG. 8 may boost the analog audio signal for generating high voltage output and then amplify the boosted analog audio signal.

Meanwhile, as illustrated in FIG. 8, the boost amplifier 830 may include at least two sub-amplifiers (e.g., Sub-Amp 1, Sub-Amp2, Sub-Amp3, ..., Sub-AmpN). The at least two sub-amplifiers may be disposed in parallel with each other in the boost amplifier 830. The signal to noise ratio (SNR) of the analog audio signal boosted by the boost amplifier 830 may increase based on the parallel connection between the at least two sub-amplifiers.

Specifically, analog audio signals boosted by at least two sub-amplifiers may be correlated with each other. For example, analog audio signals boosted by N sub-amplifiers connected in parallel may increase by N times. On the other hand, the boost amplifier noise generated in at least two sub-amplifiers may not be correlated with each other. For example, the boost amplifier noise generated in N sub-amplifiers connected in parallel may be increased by $\sqrt{N}$ times. As described above, the signal to noise ratio of the analog audio signal may increase based on the correlation difference between the analog audio signal and the boost amplifier noise in the N sub-amplifiers connected in parallel.

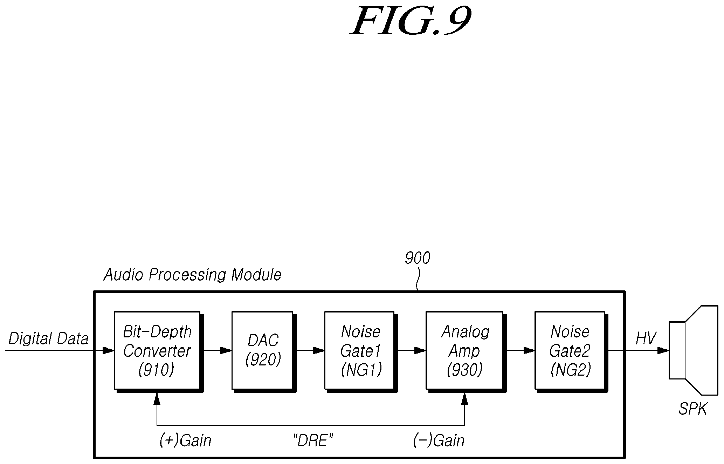

FIG. 9 is a block diagram illustrating an audio processing module 900 according to an embodiment.

Referring to FIG. 9, an audio processing module 900 (e.g., the audio processing module 340 of FIG. 3) may include a bit-depth converter 910, a DAC 920, a first noise gate NG1, an analog amplifier 930, and a second noise gate NG2. The audio processing module 900 may include a bit-depth converter 910 in which the digital amplifier and the boost amplifier are integrated.

The bit-depth converter 910 and the analog amplifier 930 may perform dynamic range enhancement (DRE) by setting the positive (+) digital gain and the negative (-) analog gain so that a total gain of the positive (+) digital gain and the negative (-) analog gain becomes 0dB.

Further, the bit-depth converter 910 may generate a high voltage output for driving the piezo speaker by boosting the digital audio signal. For example, the bit-depth converter 910 may increase the digital gain by changing a bit depth of the digital audio signal. For example, the bit-depth converter 910 may output a digital audio signal (e.g., 32-bit float) by increasing the bit depth of the input audio signal (e.g., 24-bit fixed). Since a headroom is secured as the bit depth increases, the digital audio signal (e.g., 32bit float) may be prevented from overflowing, and a high digital gain may be applied thereto.

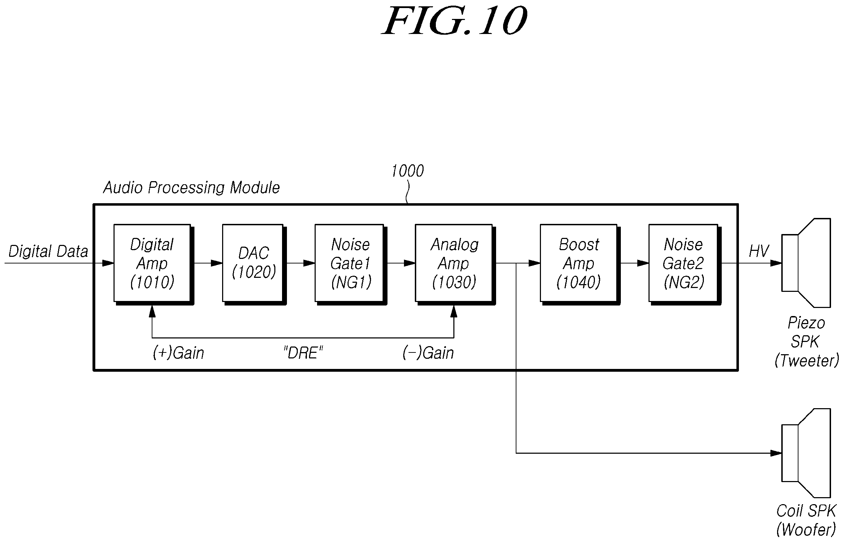

FIG. 10 is a block diagram illustrating an audio processing module 1000 according to an embodiment.

Referring to FIG. 10, an audio processing module 1000 (e.g., the audio processing module 340 of FIG. 3) may include a digital amplifier 1010, a DAC 1020, a first noise gate NG1, an analog amplifier 1030, a boost amplifier 1040, and a second noise gate NG2. Like the audio processing module 400 of FIG. 4, the digital amplifier 1010 and the analog amplifier 1030 may perform dynamic range enhancement (DRE) by setting the positive (+) digital gain and the negative (-) analog gain so that a total gain of the positive (+) digital gain and the negative (-) analog gain becomes 0dB. Further, like the audio processing module 400 of FIG. 4, the boost amplifier 1040 may generate a high voltage output for driving the piezo speaker by boosting the analog audio signal.

In an embodiment, the DAC 1020 may be implemented as a multi-DAC to separate and process at least two or more channels. For example, the DAC 1020 may be implemented as a 2-DAC 1020 to process the left channel and the right channel.

In an embodiment, the at least one speaker may be implemented as a two-way speaker. For example, the at least one speaker may include a coil speaker operating as a woofer and a piezo speaker operating as a tweeter. The analog audio signal output from the analog amplifier 1030 may be branched and output to at least one of the coil speaker and the piezo speaker. The coil speaker may receive the first analog audio signal amplified by the analog amplifier 1030. The piezo speaker may receive a second analog audio signal obtained by boosting the first analog audio signal to the reference high voltage or more by the boost amplifier 1040 and removing the analog amplifier noise generated in the analog amplifier 1030 and the boost amplifier noise generated in the boost amplifier 1040 by the second noise gate NG2.

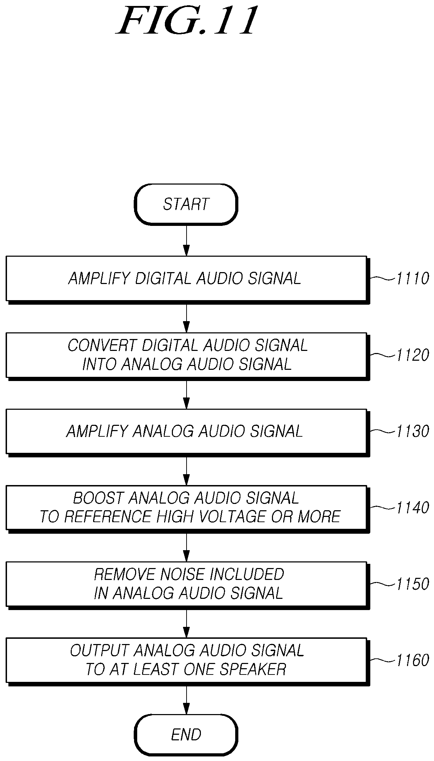

FIG. 11 is a view illustrating a sound output method using an electronic device according to an embodiment. For example, the sound output method illustrated in FIG. 11 may be implemented based on the electronic device 101 of FIG. 1.

According to an example, in operation 1110 of the sound output method, the digital amplifier (e.g., the digital amplifier 410 of FIG. 4) may amplify the digital audio signal in a digital manner by applying a digital gain to the digital audio signal. For example, the digital amplifier may amplify the magnitude of the output digital audio signal by converting the input digital audio signal into a number and adjusting the size of the number multiplied by the digital audio signal.

According to an example, in operation 1120 of the sound output method, the DAC (e.g., the DAC 420 of FIG. 4) may receive the digital audio signal from the digital amplifier (e.g., the digital amplifier 410 of FIG. 4) and may convert the digital audio signal into an analog audio signal. For example, the DAC may generate an analog audio signal by converting the digital audio signal from the binary number to an analog voltage.

According to an example, in operation 1130 of the sound output method, the analog amplifier (e.g., the analog amplifier 430 of FIG. 4) may amplify the analog audio signal in an analog manner by applying an analog gain to the analog audio signal. For example, the analog amplifier may amplify the magnitude of the output analog audio signal by adjusting the voltage multiplied by the input analog audio signal.

In an embodiment, the sound output method may perform dynamic range enhancement (DRE) on the input audio signal. The DRE may increase the dynamic range of the input audio signal and minimize noise and distortion of the input audio signal. For example, amplifying the digital audio signal may apply a positive (+) digital gain to the digital audio signal. For example, amplifying the analog audio signal may apply a negative (-) analog gain to the analog audio signal.

Amplifying the digital audio signal and amplifying the analog audio signal may perform dynamic range enhancement (DRE) by setting the positive (+) digital gain and the negative (-) analog gain so that a total gain of the positive (+) digital gain and the negative (-) analog gain becomes 0dB.

According to an example, in operation 1140 of the sound output method, the boost amplifier (e.g., the boost amplifier 440 of FIG. 4) may boost the analog audio signal to a reference high voltage or more. For example, the boost amplifier may generate a high voltage output for driving the piezo speaker by boosting the analog audio signal. The reference high voltage may be a minimum voltage for driving the piezo speaker.

According to an example, in operation 1150 of the sound output method, at least one noise gate (e.g., the noise gate NG of FIG. 4) may remove noise included in the analog audio signal. For example, the at least one noise gate may remove at least one of DAC noise generated in the DAC, analog amplifier noise generated in the analog amplifier, or boost amplifier noise generated in the boost amplifier. The at least one noise gate may output the noise-removed analog audio signal to the at least one speaker.

According to an example, in operation 1160 of the sound output method, the audio processing module may output the analog audio signal to at least one speaker. The at least one speaker may include a piezo speaker. For example, the audio processing module may output a high voltage output where the analog audio signal has been boosted to at least one piezo speaker.

At least one speaker may output sound based on the analog audio signal. For example, the at least one piezo speaker may receive, from the audio processing module, the high voltage output where the analog audio signal has been boosted, and output a high-resolution sound to the user based on the analog audio signal.

As such, an electronic device outputting a sound and a sound output method using the electronic device according to the disclosure may implement a noise-minimized, high-resolution sound by performing dynamic range enhancement (DRE) on an input audio signal and removing noise generated while processing audio, using a noise gate.

Further, an electronic device outputting a sound and a sound output method using the electronic device according to the disclosure may drive a piezo speaker which requires high-voltage output by boosting an input audio signal to a reference high voltage or more.

However, since this has been described above, no duplicate description is given.

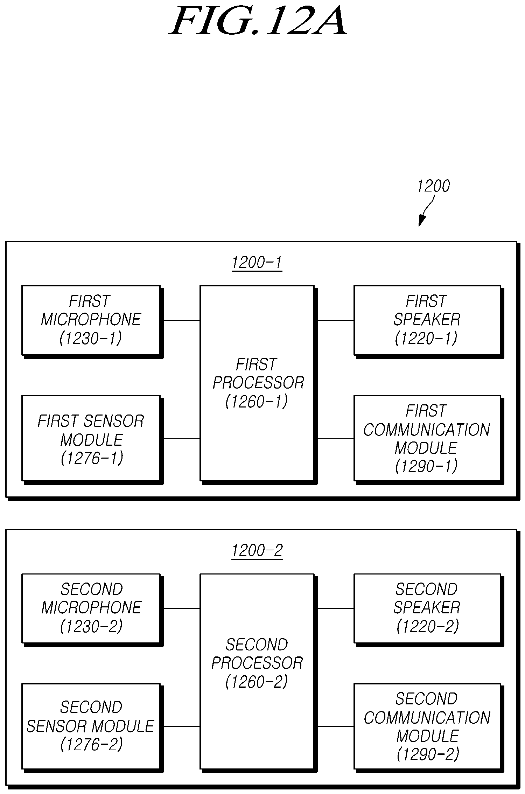

FIG. 12A is a block diagram illustrating a configuration of a wearable electronic device according to an embodiment.

Referring to FIG. 12A, the wearable electronic device 1200 may include a first wireless earphone 1200-1 and a second wireless earphone 1200-2. The first wireless earphone 1200-1 and the second wireless earphone 1200-2 may include substantially the same or similar configurations. The first wireless earphone 1200-1 and the second wireless earphone 1200-2 may perform substantially the same or similar functions. The wearable electronic device 1200 may include at least some of the components included in the electronic device 101 illustrated in FIG. 1. For example, the wearable electronic device 1200 may include the audio module 170 of FIG. 1.

In an embodiment, the first wireless earphone 1200-1 may include a first speaker 1220-1, a first microphone 1230-1, a first sensor module 1276-1, a first processor 1260-1, and/or a first communication module 1290-1.

In an embodiment, the second wireless earphone 1200-2 may include a second speaker 1220-2, a second microphone 1230-2, a second sensor module 1276-2, a second processor 1260-2, and/or a second communication module 1290-2.

In an embodiment, the wearable electronic device 1200 (e.g., the first wireless earphone 1200-1 and/or the second wireless earphone 1200-2) may be operatively connected to the electronic device (e.g., the electronic device 101 of FIG. 1) through wireless communication, and may transmit and/or receive various information.

According to various embodiments, the first speaker 1220-1 and/or the second speaker 1220-2 may include the sound output module 155 of FIG. 1. The first microphone 1230-1 and/or the second microphone 1230-2 may include the input module 150 of FIG. 1. The first sensor module 1276-1 and/or the second sensor module 1276-2 may include the sensor module 176 of FIG. 1. The first processor 1260-1 and/or the second processor 1260-2 may include the processor 120 of FIG. 1. The first communication module 1290-1 and/or the second communication module 1290-2 may include the communication module 190 of FIG. 1. For example, the first speaker 1220-1 may include at least one of a tweeter speaker and a coil speaker. For example, the second speaker 1220-2 may include at least one of a tweeter speaker and a coil speaker.

In an embodiment, the first speaker 1220-1 and/or the second speaker 1220-2 may generate analog sound based on an input signal (e.g., a sound signal and/or an audio signal) input to the wearable electronic device 1200. The first speaker 1220-1 and/or the second speaker 1220-2 may output the analog sound to the user through a speaker hole.

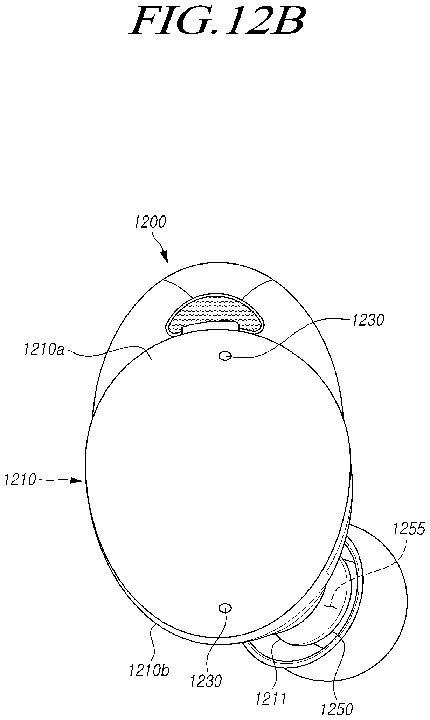

In an embodiment, the first microphone 1230-1 and/or the second microphone 1230-2 may receive a sound (e.g., a sound signal and/or an audio signal) generated around the wearable electronic device 1200. The first microphone 1230-1 and/or the second microphone 1230-2 may convert sound input through a sound hole (e.g., the sound hole 1255 of FIG. 12B) into an electrical signal. The first microphone 1230-1 may transfer the converted electrical signal to the first processor 1260-1, and the second microphone 1230-2 may transfer the converted electrical signal to the second processor 1260-2.

In an embodiment, the first sensor module 1276-1 and/or the second sensor module 1276-2 may detect the rotation direction, the rotation speed, and/or the rotation angle of the wearable electronic device 1200. The first sensor module 1276-1 and/or the second sensor module 1276-2 may include a gyro sensor (e.g., a rotation detection sensor) and/or an acceleration sensor. For example, the gyro sensor (e.g., a rotation detection sensor) may measure the signal related to the angular velocity and/or the angle acting with respect to each axis of the wearable electronic device 1200. For example, the gyro sensor (e.g., a rotation detection sensor) may measure the amount of change in the rotation angle per time unit of the roll, pitch, and yaw axes about the reference axis. For example, the acceleration sensor may measure a signal related to acceleration of the wearable electronic device 1200. For example, the acceleration sensor may measure rotation angles of roll, pitch, and yaw axes about the reference axis.

In an embodiment, the first communication module 1290-1 and/or the second communication module 1290-2 may receive and/or transmit various information by communicating with the electronic device 101 and/or an external electronic device 102, 104, or 108 of FIG. 1 through a network (e.g., the first network 198 and/or the second network 199 of FIG. 1).

In an embodiment, the first processor 1260-1 may be electrically connected to the first communication module 1290-1, and the second processor 1260-2 may be electrically connected to the second communication module 1290-2. The first processor 1260-1 may process various information received from the electronic device 101 and/or the external electronic device 102, 104, or 108 through the first communication module 1290-1. The second processor 1260-2 may process various information received from the electronic device 101 and/or the external electronic device 102, 104, or 108 through the second communication module 1290-2. The first processor 1260-1 may transfer various information to the electronic device 101 and/or the external electronic device 102, 104, or 108 through the first communication module 1290-1. The second processor 1260-2 may transfer various information to the electronic device 101 and/or the external electronic device 102, 104, or 108 through the second communication module 1290-2.

In an embodiment, the first processor 1260-1 may be operatively or electrically connected to the first speaker 1220-1, the first microphone 1230-1, the first sensor module 1276-1, and the first communication module 1290-1. The second processor 1260-2 may be operatively or electrically connected to the second speaker 1220-2, the second microphone 1230-2, the second sensor module 1276-2, and the second communication module 1290-2.

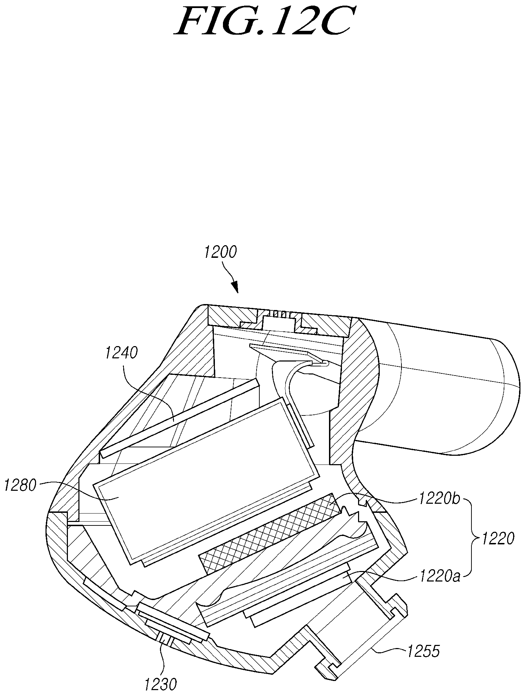

FIG. 12B illustrates an external configuration of a wearable electronic device according to an embodiment, and FIG. 12C illustrates an internal configuration of a wearable electronic device according to an embodiment.

In an embodiment, the wearable electronic device 1200 illustrated in FIGS. 12B and 12C may be the first wireless earphone 1200-1 or the second wireless earphone 1200-2 illustrated in FIG. 12A. Further, the wearable electronic device 1200 illustrated in FIGS. 12B and 12C may include substantially the same embodiments described in connection with the first wireless earphone 1200-1 or the second wireless earphone 1200-2 illustrated in FIG. 12A.

In an embodiment, the wearable electronic device 1200 may be worn on the user's ear and may output sound of music or video or may process the user's voice. In an embodiment, the wearable electronic device 1200 may operate independently through a standalone method or may operate in association with an external electronic device (e.g., the electronic device 101, the electronic devices 102, 104, and/or the server 108 of FIG. 1) through an interaction method. For example, when the wearable electronic device 1200 operates through the standalone method, the wearable electronic device 1200 may output a sound corresponding to music or video being reproduced on its own, or may receive and process the user's voice. For example, when the wearable electronic device 1200 operates through the interaction method, the wearable electronic device 1200 may be paired with the electronic device (e.g., the electronic device 101 of FIG. 1) such as a smartphone through Bluetooth communication, and may convert data received from the electronic device (e.g., the electronic device 101 of FIG. 1) to output sound or may receive the user's voice and may transmit the user's voice to the electronic device (e.g., the electronic device 101 of FIG. 1).

Referring to FIGS. 12B and 12C, the wearable electronic device 1200 (e.g., a first wireless earphone 1200-1 and/or a second wireless earphone 1200-2) may include a housing 1210, a speaker 1220 (e.g., a first speaker 1220-1 or a second speaker 1220-2), a microphone 1230 (e.g., a first microphone 1230-1 or a second microphone 1230-2), a printed circuit board 1240, a sound hole cover 1250, a sensor module 1276 (e.g., a first sensor module 1276-1 or a second sensor module 1276-2), and/or a battery 1280.

According to various embodiments, the wearable electronic device 1200 is not limited to the above-described configuration, and may further include other various components.

In an embodiment, the housing 1210 may receive and protect the speaker 1220 (e.g., the first speaker 1220-1 or the second speaker 1220-2), the microphone 1230 (e.g., the first microphone 1230-1 or the second microphone 1230-2), the printed circuit board 1240, and/or the sensor module 1276 (e.g., the first sensor module 1276-1 or the second sensor module 1276-2). The housing 1210 may include a first housing 1210a (e.g., an upper housing) and a second housing 1210b (e.g., a lower housing). The first housing 1210a (e.g., the upper housing) and the second housing 1210b (e.g., the lower housing) may be detachably coupled to each other. The first housing 1210a (e.g., the upper housing) and the second housing 1210b (e.g., the lower housing) may be integrally formed.

In an embodiment, the housing 1210 may include a protrusion 1211 to be inserted into the user's ear. The housing 1210 may be integrally connected to the protrusion 1211. The protrusion 1211 may form a portion of the housing 1210. For example, the protrusion 1211 may protrude outward from a portion of the housing 1210 in a substantially cylindrical shape. The protrusion 1211 may include a sound hole 1255 therein. For example, the sound hole 1255 may include a speaker hole (not shown) communicating with the speaker 1220 (e.g., the first speaker 1220-1 or the second speaker 1220-2) and/or a microphone hole (not shown) communicating with the microphone 1230 (e.g., the first microphone 1230-1 or the second microphone 1230-2). In an embodiment, the speaker hole (not shown) and the microphone hole (not shown) may be physically separated by a partition. According to various embodiments, the speaker hole (not shown) and the microphone hole (not shown) may not be separated by the partition.

In an embodiment, the speaker 1220 (e.g., the first speaker 1220-1 or the second speaker 1220-2) may convert an electrical signal into sound (e.g., an audio signal) and may output the converted sound through the sound hole 1255. The speaker 1220 may receive an electrical signal from a processor (e.g., a first processor 1260-1 or a second processor 1260-2) disposed on the printed circuit board 1240. In an embodiment, the speaker 1220 (e.g., the first speaker 1220-1 or the second speaker 1220-2) may have a cylindrical shape. The speaker 1220 (e.g., the first speaker 1220-1 or the second speaker 1220-2) may be electrically connected to the printed circuit board 1240.

For example, as illustrated in FIG. 12C, the speaker 1220 (e.g., the first speaker 1220-1 or the second speaker 1220-2) may include at least one of a tweeter speaker 1220a and a woofer speaker 1220b. The tweeter speaker 1220a is a speaker unit that outputs a high-pitched frequency and may be in charge of a high-pitched area of the speaker. For example, the tweeter speaker 1220a may have a small diaphragm and a narrow vibration range, and emphasize a high-pitched output. The woofer speaker 1220b is a large speaker unit that outputs a low-pitched frequency and may be in charge of a low-pitched area of the speaker. For example, the woofer speaker 1220b may have a large diaphragm and a wide vibration range, and may emphasize a low-pitched output.

In an embodiment, at least one of the tweeter speaker 1220a and the woofer speaker 1220b may be implemented as a piezo speaker (e.g., the speaker SPK of FIG. 4). For example, at least one of the tweeter speaker 1220a and the woofer speaker 1220b may be at least one of a disk piezo speaker, a bass strip piezo speaker, a tweeter piezo speaker, a glass/ceramic piezo speaker, and a plain form piezo speaker. For example, the piezo speaker (e.g., the speaker SPK of FIG. 4) is a tweeter speaker 1220a that outputs a high-pitched frequency and may be in charge of the high-pitched area. For example, the piezo speaker (e.g., the speaker SPK of FIG. 4) is a woofer speaker 1220b that outputs a low-pitched frequency and may be in charge of the low-pitched area. For example, the piezo speaker (e.g., the speaker SPK of FIG. 4) is an integrated speaker that outputs both a high-pitched frequency and a low-pitched frequency, and may be in charge of both the high-pitched area and the low-pitched area.

In an embodiment, the microphone 1230 (e.g., the first microphone 1230-1 or the second microphone 1230-2) may convert the sound input through the sound hole 1255 into an electrical signal. The microphone 1230 (e.g., the first microphone 1230-1 or the second microphone 1230-2) may transfer the converted electrical signal to the processor (e.g., the first processor 1260-1 or the second processor 1260-2) disposed on the printed circuit board 1240. In an embodiment, the microphone 1230 (e.g., the first microphone 1230-1 or the second microphone 1230-2) may include at least one external microphone and/or at least one internal microphone. For example, referring to FIG. 12A, at least one external microphone may be disposed on an outer surface of the housing 1210 (e.g., the first housing 1210a). For example, at least one internal microphone may be disposed adjacent to the printed circuit board 1240 in the housing 1210.

In an embodiment, the processor (e.g., the first processor 1260-1 or the second processor 1260-2) may be disposed on the printed circuit board 1240. The processor (e.g., the first processor 1260-1 or the second processor 1260-2) may be electrically connected to the speaker 1220, the microphone 1230, and the sensor module 1276. The processor (e.g., the first processor 1260-1 or the second processor 1260-2) may process signals related to the speaker 1220, the microphone 1230, and the sensor module 1276. The printed circuit board 1240 may include a flexible printed circuit board.

In an embodiment, the sound hole cover 1250 may be disposed on an end portion of the protrusion 1211. The sound hole cover 1250 may cover the end portion of the protrusion 1211. The housing 1210 may prevent foreign substances from entering the sound hole 1255 through the sound hole cover 1250. The sound hole cover 1250 may include at least one hole to allow sound to enter and exit through the sound hole 1255. According to an embodiment, the sound hole cover 1250 may include a grill mesh.

In an embodiment, the sensor module 1276 (e.g., the first sensor module 1276-1 or the second sensor module 1276-2) may be electrically connected to the processor (e.g., the first processor 1260-1 or the second processor 1260-2) disposed on the printed circuit board 1240. The sensor module 1276 (e.g., the first sensor module 1276-1 or the second sensor module 1276-2) may detect the rotation direction, the rotation speed, and/or the rotation angle of the wearable electronic device 1200. For example, the sensor module 1276 (e.g., the first sensor module 1276-1 or the second sensor module 1276-2) may include a gyro sensor (e.g., a rotation detection sensor) and/or an acceleration sensor.

In an embodiment, the battery 1280 may supply power to at least one component (e.g., the speaker 1220, the microphone 1230, the printed circuit board 1240, or the sensor module 1276) of the wearable electronic device 1200. For example, the battery 1280 may include at least one of a rechargeable secondary battery and a fuel cell.

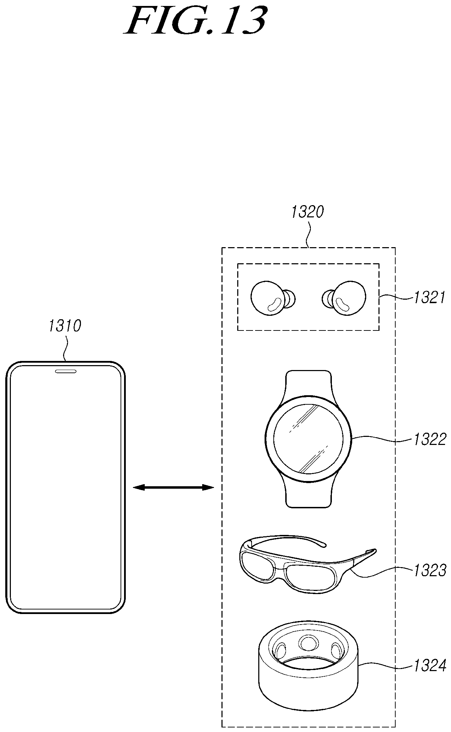

FIG. 13 illustrates a wearable device 1320 electrically connected to an electronic device 1310 according to an embodiment.

Referring to FIG. 13, an electronic device 1310 and at least one wearable device 1320 may perform data communication.

The electronic device 1310 may generate input data and output the input data to at least one wearable device 1320. For example, the input data may include an input audio signal. For example, the electronic device 1310 may be at least one of a smartphone, a tablet PC, a camera, a television, a home system control device, and a car.

The at least one wearable device 1320 may perform a predetermined function based on input data received from the electronic device 1310. For example, the at least one wearable device 1320 may generate an analog audio signal based on the input audio signal received from the electronic device 1310 and may output sound based on the analog audio signal. For example, the at least one wearable device 1320 may include at least one of a smart earphone 1321, a smart watch 1322, a smart glass 1323, and a smart ring 1324.

According to an embodiment, the at least one wearable device 1320 may include an audio processing module (e.g., the audio processing module 400 of FIG. 4) and a speaker (e.g., the speaker SPK of FIG. 4). For example, the at least one wearable device 1320 may include at least one of a digital amplifier amplifying a digital audio signal, a DAC converting the digital audio signal into an analog audio signal, an analog amplifier amplifying the analog audio signal, a boost amplifier boosting the analog audio signal to a reference high voltage or more, and at least one noise gate removing noise included in the analog audio signal. For example, the speaker may include a piezo speaker.

Accordingly, the at least one wearable device 1320 may implement a noise-minimized, high-resolution sound by performing DRE on an input audio signal and removing noise generated while processing audio, using the noise gate.

An electronic device (e.g., the electronic device 101 of FIG. 1) outputting a sound according to embodiments of the disclosure may comprise memory (e.g., the memory 130 of FIG. 1) storing at least one instruction, a processor (e.g., the processor 120 of FIG. 1) executing the at least one instruction, at least one speaker (e.g., the sound output module 155 of FIG. 1), and an audio processing module (e.g., the audio module 170 of FIG. 1) processing an input audio signal and outputting the processed input audio signal to the at least one speaker. The audio processing module may include a digital amplifier (e.g., the digital amplifier 410 of FIG. 4) amplifying a digital audio signal, a digital-to-analog converter (DAC) (e.g., the DAC 420 of FIG. 4) converting the digital audio signal into an analog audio signal, an analog amplifier (e.g., the analog amplifier 430 of FIG. 4) amplifying the analog audio signal, a boost amplifier (e.g., the boost amplifier 440 of FIG. 4) boosting the analog audio signal to a reference high voltage or more, and at least one noise gate (e.g., the noise gate NG of FIG. 4) removing noise included in the analog audio signal. The digital amplifier may apply a positive (+) digital gain to the digital audio signal. The analog amplifier may apply a negative (-) analog gain to the analog audio signal.

In an embodiment, the digital amplifier and the analog amplifier may perform dynamic range enhancement (DRE) by setting the positive (+) digital gain and the negative (-) analog gain so that a total gain of the positive (+) digital gain and the negative (-) analog gain becomes 0dB.

In an embodiment, the at least one speaker may include a piezo speaker. The reference high voltage may be a minimum voltage for driving the piezo speaker.

In an embodiment, the at least one noise gate may remove analog amplifier noise generated in the analog amplifier and boost amplifier noise generated in the boost amplifier.

In an embodiment, a threshold level of the at least one noise gate may be determined by Equation 1:

[Equation 1]

$$TL = (Noise_{AA} \times Gain_{BA}) + Noise_{BA}$$

Here, TL is the threshold level of the at least one noise gate, $Noise_{AA}$ is the analog amplifier noise, $Gain_{BA}$ is a boost amplifier gain, and $Noise_{BA}$ is the boost amplifier noise.

In an embodiment, the at least one noise gate may remove DAC noise generated in the DAC.

In an embodiment, the at least one noise gate may include a first noise gate disposed between the DAC and the analog amplifier to remove DAC noise generated in the DAC and a second noise gate disposed between the boost amplifier and the at least one speaker to remove analog amplifier noise and boost amplifier noise.

In an embodiment, the at least one noise gate may include a first noise gate disposed between the DAC and the analog amplifier to remove DAC noise generated in the DAC, a second noise gate disposed between the boost amplifier and the at least one speaker to remove boost amplifier noise, and a third noise gate disposed between the analog amplifier and the boost amplifier to remove analog amplifier noise.

In an embodiment, the at least one noise gate may include a first noise gate disposed between the DAC and the boost amplifier to remove DAC noise generated in the DAC and a second noise gate disposed between the analog amplifier and the at least one speaker to remove boost amplifier noise and analog amplifier noise.

In an embodiment, the boost amplifier may include at least two sub-amplifiers. A signal to noise ratio (SNR) of the analog audio signal boosted by the boost amplifier may be increased based on a parallel connection between the at least two sub-amplifiers.

In an embodiment, the audio processing module may include a bit-depth converter in which the digital amplifier and the boost amplifier are integrated. The bit-depth converter may increase the digital gain by changing a bit depth of the digital audio signal.

In an embodiment, the at least one speaker may include a coil speaker and a piezo speaker. The coil speaker may receive a first analog audio signal amplified by the analog amplifier. The piezo speaker may receive a second analog audio signal obtained by boosting the first analog audio signal to the reference high voltage or more by the boost amplifier.

An audio processing module (e.g., the audio processing module 400 of FIG. 4) processing an input audio signal and outputting the processed input audio signal to at least one speaker according to embodiments of the disclosure may comprise a digital amplifier (e.g., the digital amplifier 410 of FIG. 4) amplifying a digital audio signal, a digital-to-analog converter (DAC) (e.g., the DAC 420 of FIG. 4) converting the digital audio signal into an analog audio signal, an analog amplifier (e.g., the analog amplifier 430 of FIG. 4) amplifying the analog audio signal, a boost amplifier (e.g., the boost amplifier 440 of FIG. 4) boosting the analog audio signal to a reference high voltage or more, and at least one noise gate (e.g., the noise gate NG of FIG. 4) removing noise included in the analog audio signal. The digital amplifier may apply a positive (+) digital gain to the digital audio signal. The analog amplifier may apply a negative (-) analog gain to the analog audio signal.

In an embodiment, the digital amplifier and the analog amplifier may perform dynamic range enhancement (DRE) by setting the positive (+) digital gain and the negative (-) analog gain so that a total gain of the positive (+) digital gain and the negative (-) analog gain becomes 0dB.

In an embodiment, the at least one speaker may include a piezo speaker. The reference high voltage may be a minimum voltage for driving the piezo speaker.

In an embodiment, the at least one noise gate may remove analog amplifier noise generated in the analog amplifier and boost amplifier noise generated in the boost amplifier.

A method for outputting a sound according to embodiments of the disclosure may comprise amplifying a digital audio signal, converting the digital audio signal into an analog audio signal, amplifying the analog audio signal, boosting the analog audio signal to a reference high voltage or more, removing noise included in the analog audio signal, and outputting the analog audio signal to at least one speaker. Amplifying the digital audio signal may apply a positive (+) digital gain to the digital audio signal. Amplifying the analog audio signal may apply a negative (-) analog gain to the analog audio signal.

In an embodiment, amplifying the digital audio signal and amplifying the analog audio signal may perform dynamic range enhancement (DRE) by setting the positive (+) digital gain and the negative (-) analog gain so that a total gain of the positive (+) digital gain and the negative (-) analog gain becomes 0dB.

In an embodiment, the at least one speaker may include a piezo speaker. The reference high voltage may be a minimum voltage for driving the piezo speaker.

In an embodiment, removing the noise included in the analog audio signal may remove analog amplifier noise generated in the analog amplifier and boost amplifier noise generated in the boost amplifier.

It should be appreciated that various embodiments of the disclosure and the terms used therein are not intended to limit the technological features set forth herein to particular embodiments and include various changes, equivalents, or replacements for a corresponding embodiment. As used herein, the singular forms "a," "an," and "the" are intended to include the plural forms as well, unless the context clearly indicates otherwise. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order).

As used herein, the term "part" or "module" may include a unit implemented in hardware, software, or firmware, and may interchangeably be used with other terms, for example, "logic," "logic block," "part," or "circuitry". A part or module may be a single integral component, or a minimum unit or part thereof, adapted to perform one or more functions. For example, according to an embodiment, 'part' or 'module' may be implemented in a form of an application-specific integrated circuit (ASIC).

As used in various embodiments of the disclosure, the term "if' may be interpreted as "when," "upon," "in response to determining," or "in response to detecting," depending on the context. Similarly, "if A is determined" or "if A is detected" may be interpreted as "upon determining A" or "in response to determining A", or "upon detecting A" or "in response to detecting A", depending on the context.

The program executed by the electronic device 200 described herein may be implemented as a hardware component, a software component, and/or a combination thereof. The program may be executed by any system capable of executing computer readable instructions.

The software may include computer programs, codes, instructions, or combinations of one or more thereof and may configure the processing device as it is operated as desired or may instruct the processing device independently or collectively. The software may be implemented as a computer program including instructions stored in computer-readable storage media. The computer-readable storage media may include, e.g., magnetic storage media (e.g., read-only memory (ROM), random-access memory (RAM), floppy disk, hard disk, etc.) and an optically readable media (e.g., CD-ROM or digital versatile disc (DVD). Further, the computer-readable storage media may be distributed to computer systems connected via a network, and computer-readable codes may be stored and executed in a distributed manner. The computer program may be distributed (e.g., downloaded or uploaded) via an application store (e.g., Play Store™), directly between two UEs (e.g., smartphones), or online. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

1. An audio processing module (400) processing an input audio signal and outputting the processed input audio signal to the at least one speaker, wherein the audio processing module includes:

   a digital amplifier (410) amplifying a digital audio signal;
   a digital-to-analog converter (DAC) (420) converting the digital audio signal into an analog audio signal;
   an analog amplifier (430) amplifying the analog audio signal;

a boost amplifier (440) boosting the analog audio signal to a reference high voltage or more; and

at least one noise gate (NG) removing noise included in the analog audio signal,

wherein the digital amplifier applies a positive (+) digital gain to the digital audio signal, and

wherein the analog amplifier applies a negative (-) analog gain to the analog audio signal.

2. The audio processing module of claim 1, wherein the digital amplifier and the analog amplifier perform dynamic range enhancement (DRE) by setting the positive (+) digital gain and the negative (-) analog gain so that a total gain of the positive (+) digital gain and the negative (-) analog gain becomes 0dB.

3. The audio processing module of any one of the preceding claims, wherein the at least one noise gate removes analog amplifier noise generated in the analog amplifier and boost amplifier noise generated in the boost amplifier and/or wherein the at least one noise gate removes DAC noise generated in the DAC.

4. The audio processing module of claim 3, wherein a threshold level of the at least one noise gate is determined by Equation 1:

[Equation 1]

$$TL=(Noise_{AA} \times Gain_{BA})+Noise_{BA}$$

Here, TL is the threshold level of the at least one noise gate, $Noise_{AA}$ is the analog amplifier noise, $Gain_{BA}$ is a boost amplifier gain, and $Noise_{BA}$ is the boost amplifier noise.

5. The audio processing module of any one of the preceding claims, wherein the at least one noise gate includes:

a first noise gate disposed between the DAC and the analog amplifier to remove DAC noise generated in the DAC; and

a second noise gate disposed between the boost amplifier and the at least one speaker to remove analog amplifier noise and boost amplifier noise.

6. The audio processing module of any one of the preceding claims, wherein the at least one noise gate includes:

a first noise gate disposed between the DAC and the analog amplifier to remove DAC noise generated in the DAC;

a second noise gate disposed between the boost amplifier and the at least one speaker to remove boost amplifier noise; and

a third noise gate disposed between the analog amplifier and the boost amplifier to remove analog amplifier noise.

7. The audio processing module of any one of the preceding claims, wherein the at least one noise gate includes:

a first noise gate disposed between the DAC and the boost amplifier to remove DAC noise generated in the DAC; and

a second noise gate disposed between the analog amplifier and the at least one speaker to remove boost amplifier noise and analog amplifier noise.

8. The audio processing module of claim 7, wherein the boost amplifier includes at least two sub-amplifiers, and

wherein a signal to noise ratio (SNR) of the analog audio signal boosted by the boost amplifier is increased based on a parallel connection between the at least two sub-amplifiers.

9. The audio processing module electronic device of any one of the preceding claims, further includes a bit-depth converter in which the digital amplifier and the boost amplifier are integrated, and

wherein the bit-depth converter increases the digital gain by changing a bit depth of the digital audio signal.

10. An electronic device outputting a sound, comprising:

memory storing at least one instruction;

a processor executing the at least one instruction;

at least one speaker; and

audio processing module according to any one of the preceding claims.

11. The electronic device of claim 10, wherein the at least one speaker includes a coil speacker and a piezo speaker, and

wherein the reference high voltage is a minimum voltage for driving the piezo speaker,

wherein the coil speaker receives a first analog audio signal amplified by the analog amplifier, and/or

wherein the piezo speaker receives a second analog audio signal obtained by boosting the first analog audio signal to the reference high voltage or more by the boost amplifier.

**12.** A method for outputting a sound, the method comprising:

amplifying (1110) a digital audio signal;
converting (1120) the digital audio signal into an analog audio signal;
amplifying (1130) the analog audio signal;
boosting (1140) the analog audio signal to a reference high voltage or more;
removing (1150) noise included in the analog audio signal; and
outputting (1160) the analog audio signal to at least one speaker,
wherein amplifying the digital audio signal includes applying a positive (+) digital gain to the digital audio signal, and
wherein amplifying the analog audio signal includes applying a negative (-) analog gain to the analog audio signal.

**13.** The method of claim 12, wherein amplifying the digital audio signal and amplifying the analog audio signal include performing dynamic range enhancement (DRE) by setting the positive (+) digital gain and the negative (-) analog gain so that a total gain of the positive (+) digital gain and the negative (-) analog gain becomes 0dB.

**14.** The method of claim 12 or 13, wherein the at least one speaker includes a piezo speaker, and wherein the reference high voltage is a minimum voltage for driving the piezo speaker.

**15.** The method of claim 12, 13, or 14, wherein removing the noise included in the analog audio signal includes removing analog amplifier noise generated in the analog amplifier and boost amplifier noise generated in the boost amplifier.

# FIG.1

EP 4 468 739 A2

# FIG.2

200

AUDIO MODULE(170)

| AUDIO INPUT INTERFACE(210) | AUDIO OUTPUT INTERFACE(270) |
|---|---|
| AUDIO INPUT MIXER (220) | AUDIO OUTPUT MIXER (260) |
| ADC (230) | DAC (250) |

AUDIO SIGNAL PROCESSOR (240)

# FIG.3

300

| AUDIO RECEPTION MODULE(310) | AUDIO PROCESSING MODULE(340) |
|---|---|
| COMMUNICATION MODULE(320) | SPEAKER (350) |
| CODEC (330) | SENSOR (360) |
| PROCESSOR (399) | MEMORY (388) |

# FIG.4

# FIG.5

EP 4 468 739 A2

Audio Processing Module

500

| | | | | | |
|---|---|---|---|---|---|
| Digital Amp (510) | DAC (520) | Noise Gate1 (NG1) | Analog Amp (530) | Boost Amp (540) | Noise Gate2 (NG2) |

Digital Data →

HV →

SPK

(+)Gain          "DRE"          (−)Gain

# FIG.6

# FIG.7

EP 4 468 739 A2

700

Audio Processing Module

Digital Data → | Digital Amp (710) | → | DAC (720) | → | Noise Gate1 (NG1) | → | Boost Amp (730) | → | Analog Amp (740) | → | Noise Gate2 (NG2) | → HV → SPK

(+)Gain          "DRE"          (−)Gain

# FIG.8

Audio Processing Module

800

Boost Amp(830)

Digital Data → Digital Amp (810) → DAC (820) → Noise Gate1 (NG1) → [Sub-Amp 1, Sub-Amp 2, Sub-Amp 3, ⋮ Sub-Amp N] → Analog Amp (840) → Noise Gate2 (NG2) → HV → SPK

(+)Gain          "DRE"          (−)Gain

EP 4 468 739 A2

# FIG.9

Audio Processing Module

900

Digital Data → Bit-Depth Converter (910) → DAC (920) → Noise Gate1 (NG1) → Analog Amp (930) → Noise Gate2 (NG2) → HV → SPK

(+)Gain        "DRE"        (−)Gain

# *FIG.10*

EP 4 468 739 A2

Audio Processing Module                                            1000

Digital Data →
```
┌─────────────────────────────────────────────────────────────────────────────┐
│  ┌─────────┐   ┌─────────┐   ┌─────────┐   ┌─────────┐   ┌─────────┐   ┌─────────┐ │
│  │ Digital │   │  DAC    │   │  Noise  │   │ Analog  │   │  Boost  │   │  Noise  │ │
│  │  Amp    │ → │ (1020)  │ → │  Gate1  │ → │   Amp   │   │   Amp   │ → │  Gate2  │ │
│  │ (1010)  │   │         │   │  (NG1)  │   │ (1030)  │   │ (1040)  │   │  (NG2)  │ │
│  └─────────┘   └─────────┘   └─────────┘   └─────────┘   └─────────┘   └─────────┘ │
└─────────────────────────────────────────────────────────────────────────────┘
```

(+)Gain            "DRE"            (−)Gain

HV → Piezo SPK (Tweeter)

Coil SPK (Woofer)

# *FIG.11*

```
                    ┌─────────────┐
                    │    START    │
                    └──────┬──────┘
                           │
                           ▼
        ┌──────────────────────────────────────┐
        │      AMPLIFY DIGITAL AUDIO SIGNAL     │ ──1110
        └──────────────────┬───────────────────┘
                           │
                           ▼
        ┌──────────────────────────────────────┐
        │       CONVERT DIGITAL AUDIO SIGNAL    │ ──1120
        │        INTO ANALOG AUDIO SIGNAL       │
        └──────────────────┬───────────────────┘
                           │
                           ▼
        ┌──────────────────────────────────────┐
        │       AMPLIFY ANALOG AUDIO SIGNAL     │ ──1130
        └──────────────────┬───────────────────┘
                           │
                           ▼
        ┌──────────────────────────────────────┐
        │       BOOST ANALOG AUDIO SIGNAL       │ ──1140
        │   TO REFERENCE HIGH VOLTAGE OR MORE   │
        └──────────────────┬───────────────────┘
                           │
                           ▼
        ┌──────────────────────────────────────┐
        │        REMOVE NOISE INCLUDED          │ ──1150
        │        IN ANALOG AUDIO SIGNAL         │
        └──────────────────┬───────────────────┘
                           │
                           ▼
        ┌──────────────────────────────────────┐
        │       OUTPUT ANALOG AUDIO SIGNAL      │ ──1160
        │        TO AT LEAST ONE SPEAKER        │
        └──────────────────┬───────────────────┘
                           │
                           ▼
                    ┌─────────────┐
                    │     END     │
                    └─────────────┘
```

# *FIG.12A*

1200

### 1200-1

FIRST
MICROPHONE
(1230-1)

FIRST
PROCESSOR
(1260-1)

FIRST
SPEAKER
(1220-1)

FIRST SENSOR
MODULE
(1276-1)

FIRST
COMMUNICATION
MODULE
(1290-1)

### 1200-2

SECOND
MICROPHONE
(1230-2)

SECOND
PROCESSOR
(1260-2)

SECOND
SPEAKER
(1220-2)

SECOND
SENSOR MODULE
(1276-2)

SECOND
COMMUNICATION
MODULE
(1290-2)

# *FIG.12B*

# FIG.12C

# *FIG.13*